Europäisches Patentamt

European Patent Office

Office européen des brevets

(11) Numéro de publication: **0 228 973 B1**

# FASCICULE DE BREVET EUROPEEN

(45) Date de publication de fascicule du brevet:
**17.04.91**

(51) Int. Cl.⁵: **H05K 13/02**, H05K 13/00

(21) Numéro de dépôt: **86420002.7**

(22) Date de dépôt: **06.01.86**

(54) Procédé et moyens de préhension et de transport des plaquettes de silicium.

(43) Date de publication de la demande:
**15.07.87 Bulletin 87/29**

(45) Mention de la délivrance du brevet:
**17.04.91 Bulletin 91/16**

(84) Etats contractants désignés:
**CH DE GB IT LI NL**

(56) Documents cités:
**WO-A-83/04240**
**FR-A- 2 474 001**
**FR-A- 2 567 160**
**US-A- 4 436 474**

**WESTERN ELECTRIC ENGINEER, vol. 20, no. 2, April 1976, pages 42-49, Western Electric Company Inc., New York, US; A.F. JOHNSON: "Contamination-free wafer handling and identification"**

**IBM TECHNICAL DISCLOSURE BULLETIN, vol. 15, no. 1, June 1972, pages 345,346, New York, US; A. LEOFF et al.: "Wafer holder"**

(73) Titulaire: **CENTRE STEPHANOIS DE RECHERCHES MECANIQUES HYDROMECANIQUE ET FROTTEMENT Société anonyme**
**Zone Industrielle Sud Rue Benoît Fourneyron**
**F-42166 Andrezieux BoutheonCédex(FR)**

(72) Inventeur: **Rey-Herme, Henry**
**Le Romanet Bard**
**F-42600 Montbrison(FR)**

(74) Mandataire: **Dupuis, François**
**Cabinet Laurent et Charras 3, place de l'Hôtel-de-Ville**
**F-42000 Saint-Etienne(FR)**

## Description

L'objet de l'invention se rattache notamment aux secteurs techniques des semi-conducteurs, des micro-composants, des circuits intégrés tels que les microprocesseurs, à leurs procédés et moyens de fabrication, à leurs applications.

La fabrication des circuits intégrés comprend notamment, après la préparation des plaquettes de silicium ou autre matériau semi-conducteur, une phase de traitement de ces plaquettes en plusieurs opérations afin de former sur chaque plaquette une pluralité de microprocesseurs ou circuits intégrés. En particulier, on exécute une opération de traitement thermique dans des fours à diffusion.

Des contraintes très rigoureuses s'attachent aux opérations de traitement des plaquettes, notamment :

- aucune particule étrangère, même infinitésimale, ne doit atteindre les plaquettes et toute forme de pollution doit être rigoureusement évitée dans les opérations, les transferts en déplacements ;
- aucun frottement, aucun contact, ne doit avoir lieu avec la face des plaquettes qui présente les circuits intégrés ou microprocesseurs.

Actuellement, les plaquettes de silicium ou autre en phase de traitement parviennent, après avoir été traitées, à proximité des fours à diffusion, dans des paniers en matière plastique qui reçoivent verticalement par exemple 25 plaquettes avec un même pas d'espacement des plaquettes (pas des encoches).

Avant de les enfourner, il faut transférer les plaquettes dans des nacelles en matériau réfractaire tel que le quartz. Les nacelles présentent des encoches latérales pour maintenir verticalement les dites plaquettes d'une manière régulière et ordonnée, mais avec un pas ou espacement sensiblement plus réduit que celui des paniers, par exemple dans le rapport de 1 à 2 (soit des nacelles de 50 plaquettes par exemple).

Ce transfert des paniers aux nacelles en vue de l'enfournement, puis des nacelles aux paniers après le défournement, s'opère fréquemment à la main, en utilisant par exemple des pipettes à vide, ou des pinces fines dites brucelles, ce qui exige une grande dextérité des opérateurs et opératrices, avec des risques sérieux et fréquents de mauvais contacts et frottements sur les faces des plaquettes qui présentent les circuits, et des pertes importantes et très coûteuses de plaquettes résultant de ces manipulations unitaires. On a proposé d'effectuer ce transfert par retournement du panier sur la nacelle, ou inversement. Il peut y avoir un gain de temps, mais cela implique des déplacements malaisés très risqués compte tenu des contraintes indiquées, avec de sérieuses complications en considérant les différences de pas. il y a aussi des pertes importantes et coûteuses de plaquettes.

On peut également citer le Brevet WO 8304240 qui met en oeuvre une plaque métallique de transfert qui vient en contact avec la plaque de silicium afin de la saisir par aspiration. Il en résulte une certaine complexité de l'ensemble qui peut nuire à la fiabilité.

Après le transfert des plaquettes sur les nacelles, on doit amener manuellement les dites nacelles sur les moyens d'introduction et de chargement dans les compartiments des fours et, après le traitement de diffusion, et le défournement des nacelles et des plaquettes, on retire manuellement les nacelles des moyens de chargement pour les placer près des paniers dans lesquels les plaquettes doivent être transférées. Ces déplacements manuels impliquent des à-coups ou risques d'à-coups, avec des irrégularités dans les manipulations et autant de risques de frottement, de pollution, avec les pertes correspondantes de plaquettes.

Le procédé et les moyens de l'invention remédient à ces inconvénients et permettent d'éliminer les risques et pertes relatifs aux plaquettes lors des transferts ; de supprimer les interventions manuelles de transferts, en vue des enfournements puis des défournements ; de concourir d'une manière déterminante à l'automatisation de l'ensemble de la fabrication des circuits intégrés ; d'améliorer très sensiblement la productivité en diminuant notablement les coûts de fabrication, les fours étant susceptibles de fonctionner sans interruption.

Le procédé de l'invention est décrit dans la revendication principale 1. Les moyens de mise en oeuvre du procédé de l'invention sont décrits dans les revendications 4 et 17. Les différents modes de réalisation de l'invention apparaissent dans les revendications dépendantes.

L'invention est exposée ci-après plus en détail à l'aide des dessins annexés :

La figure 1 Montre par une vue en perspective, une plaquette de silicium sur la face apparente de laquelle on a figuré schématiquement les circuits intégrés.

La figure 2 montre par une vue en perspective et à titre d'exemple de réalisation, un panier à plaquettes qui est généralement en TEFLON. On a illustré en traits interrompus seulement deux plaquettes positionnées dans le panier.

La figure 3 est une vue de face du panier selon figure 2. On a illustré en traits interrompus une plaquette en position d'appui au fond des encoches.

Les figures 4 et 5 illustrent, par deux vues correspondantes, les moyens poussant de bas en haut les plaquettes contenues dans le panier à la figure 5. Les plaquettes sont représentées en position élevée, pour être saisies par les moyens préhenseurs.

La figure 6 montre par une vue en perspective et à titre d'exemple de réalisation, une nacelle en quartz destinée à recevoir les plaquettes pour leur traitement dans le four de diffusion.

La figure 7 est une vue de face et en coupe de la nacelle selon figure 6. On a illustré, à titre d'exemple, une plaquette en position dans les encoches.

La figure 8 montre par une vue d'ensemble en coupe, une forme de réalisation des moyens préhenseurs mettant en oeuvre un tube hélicoïdal creux et à capacité de déformation élastique, du type Bourdon, ces moyens étant combinés avec des moyens modificateurs du pas ou intervalles entre les plaquettes. Les moyens préhenseurs sont illustrés pour trois plaquettes, à titre d'exemple non limitatif.

La figure 9 est une vue en coupe transversale considérée suivant la ligne 9-9 de la figure 8.

La figure 10 est une vue d'ensemble en coupe d'une autre forme de réalisation dans laquelle les moyens préhenseurs qui utilisent un tube hélicoïdal creux et à capacité de déformation élastique, du type Bourdon, sont combinés avec d'autres moyens modificateurs du pas ou intervalles entre les plaquettes.

La figure 11 est une coupe transversale suivant la ligne 11-11 de la figure 10.

Les figures 12, 13 et 14 sont des vues à caractère schématique qui illustrent plusieurs modes de réalisations et d'action des moyens préhenseurs agissant sur la tranche des plaquettes.

Les figures 15 et 16 sont des vues correspondantes qui montrent schématiquement un autre mode de réalisation et d'action, avec une enveloppe que l'on peut soumettre à l'action d'un fluide sous pression, des moyens préhenseurs agissant sur la tranche des plaquettes.

Les figures 17 et 18 sont des vues à caractère schématique qui illustrent d'autres modes de réalisations et d'action des moyens préhenseurs agissant sur la tranche des plaquettes.

Les figures 19, 20 et 21 illustrent par des vues correspondantes, respectivement en élévation, vue de côté en coupe suivant la ligne 20-20 de la figure 19, et vue de dessous suivant la ligne 21 de la figure 19, une autre forme de réalisation des moyens préhenseurs agissant par déformation.

Les figures 22 et 23 montrent par des vues correspondantes, respectivement en élévation et en vue de côté en coupe suivant la ligne 23-23 de la figure 22, une autre forme de réalisation des moyens préhenseurs agissant par déformation.

Les figures 24 et 25 sont des vues correspondantes, respectivement en élévation et en vue de côté en coupe suivant la ligne 25-25 de la figure 24, qui montrent une autre forme de réalisation des moyens préhenseurs agissant par déformation.

La figure 26 illustre par une vue d'ensemble générale à caractère schématique, les moyens essentiels pour opérer automatiquement, selon l'invention, l'approche du four par les plaquettes dans les paniers, le transfert des plaquettes dans les nacelles, l'enfournement, le défournement, le transfert des plaquettes dans les paniers, et l'éloignement du four en direction de l'opération suivante.

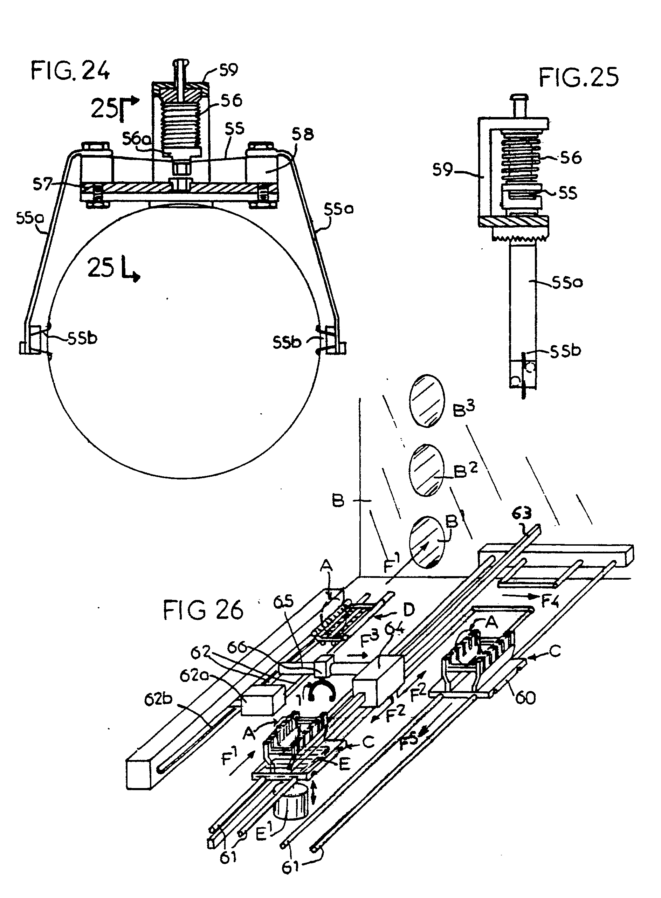

Les plaquettes de silicium sont désignées par (A). Le four à diffusion est désigné par (B), avec plusieurs compartiments tels que (B1) - (B2) - (B3) qui sont superposés dans l'exemple illustré (figure 26).

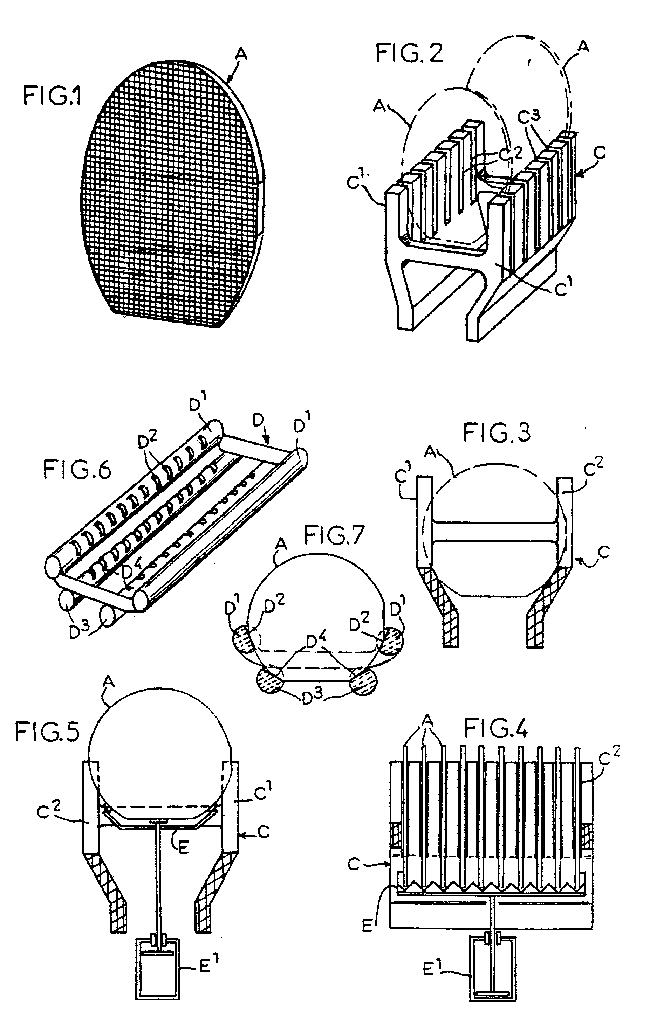

Les paniers en toute matière convenable et généralement en Téflon, sont désignés par (C) (figures 2 et 3). Ces paniers connus en eux-mêmes ont des côtés (C1) dans lesquels sont formées, du côté intérieur du panier, des encoches ou entailles (C2) dont la partie supérieure peut être ouverte à l'extérieur comme illustré en (C3). A la base des cloisons ou côtés latéraux (C1), les dits côtés sont inclinés vers l'intérieur du panier de façon à donner des appuis tangentiels à la partie inférieure des plaquettes. Les entailles ou encoches (C2) ont une largeur un peu supérieure à l'épaisseur des plaquettes (A). La partie inférieure du panier est ouverte pour laisser un libre accès permettant de déplacer les plaquettes de bas en haut dans certaines phases de fonctionnement comme il sera décrit par la suite.

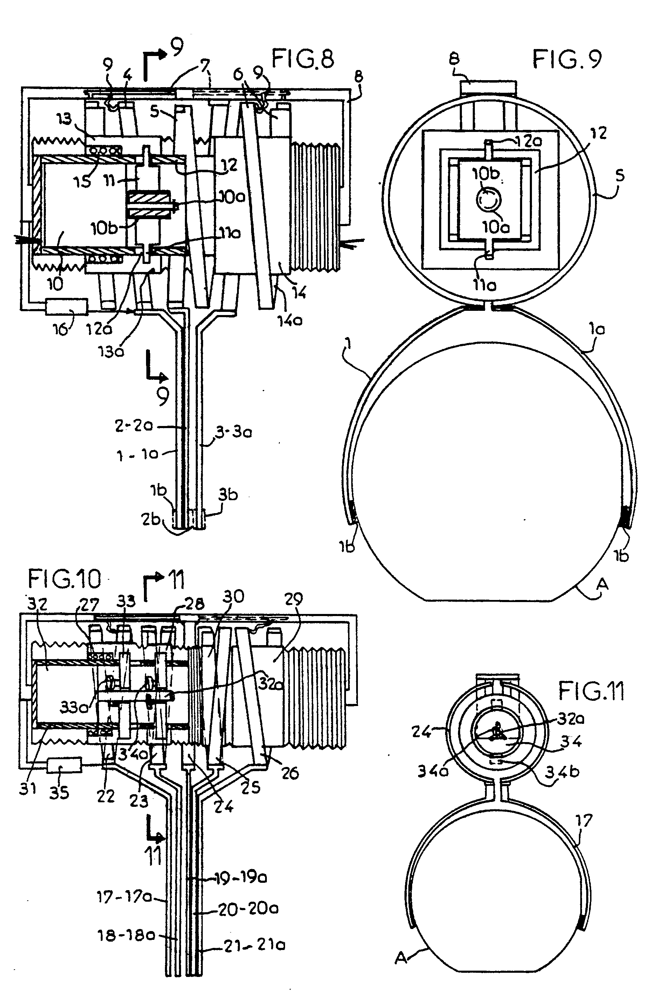

Les nacelles, connues en elles-mêmes, sont destinées à être introduites dans les fours à diffusion et sont désignées par (D) (figures 6 et 7). Ces nacelles sont en quartz ou autre matériau réfractaire et comportent deux parties longitudinales latérales (D1) présentant en (D2) des entailles ou encoches du côté intérieur de la nacelle. Les nacelles comportent aussi deux parties longitudinales inférieures (D3) qui présentent en (D4) des encouches ou entailles de positionnement et de maintien pour les plaquettes (A). Les parties longitudinales latérales (D1) sont relativement basses, de sorte qu'après mise en place des plaquettes (A), elles se trouvent sensiblement au-dessous de la plus grande dimension diamétrale, ce qui facilite la préhension sur tranche des plaquettes. Les entailles ou encoches (D2 - D4) ont une largeur et une forme qui autorise la mise en place, le positionnement et le maintien des plaquettes avec le minimum de jeu nécessaire.

Les opérations de transfert des plaquettes (A) des paniers (C) jusqu'aux nacelles (D) avant l'enfournement, et inversement après le défournement, sont délicates pour les raisons exposées, et, selon le procédé de l'invention, on met en oeuvre des moyens préhenseurs et porteurs en contact exclusivement sur la tranche de chaque plaquette (A).

Une forme de réalisation de ces moyens préhenseurs et porteurs sur tranche, est illustrée aux figures 8 et 9.

Des tiges ou branches enveloppantes (1 - 1a) - (2 -2a) - (3 - 3a) ayant une forme générale en arc par exemple, sont solidaires chacune par paire, par soudure ou autrement, des extrémités d'une spire interrompue de tubes creux, respectivement 4 - 5 - 6 , à capacité de déformation élastique, formés par exemple hélicoïdalement (du type Bourdon). Les extrémités des branches présentent en 1b - 2b -3b des parties ou conformations d'appui et de maintien d'une plaquette A . Les branches ont une épaisseur aussi réduite que possible, de façon à être compatibles avec les modifications de pas. On a illustré seulement trois parties de branches de préhension pour la clarté du dessin, mais il est évident que l'on peut augmenter ou diminuer le nombre des paires de branches.

Les tubes creux 4 - 5 - 6 sont alimentés périodiquement lorsqu'on veut libérer les plaquettes A , ou avant la prise des plaquettes, en fluide gazeux que l'on met en pression dans les tubes, ce qui a pour effet d'écarter les extrémités des spires interrompues et, par conséquent, les branches de chaque paire 1 - 1a - 2 - 2a - 3 - 3a - et les parties d'appui de ces branches. Inversement lorsqu'on cesse d'envoyer le fluide en pression dans les tubes 4 - 5 -6 , ces derniers et en particulier les extrémités interrompues, retrouvent élastiquement leurs positions rapprochées, ainsi que les paires de branches, ce qui assure la préhension des plaquettes ou une position de repos lorsqu'aucune plaquette ne doit être saisie. Les tubes sont alimentés en fluide gazeux par tout moyen connu, et par exemple à l'aide de canalisations 7 à travers le boîtier de montage 8 , et de canalisations souples 9 .

Le dispositif doit cependant, comme il a été indiqué, présenter des moyens modificateurs des intervalles entre les paires de branches 1 - 1a - 2 - 2a - 3 - 3a - et leurs parties d'appui, pour les raisons déjà indiquées.

A cet effet, le tube médian 5 qui porte les branches médianes 2 - 2a , est fixé au boîtier 8 . Le tube 5 et les branches 2 - 2a ont une position médiane fixe dans la longueur. Ce sont les tubes et les branches correspondantes qui sont déplacés symétriquement de part et d'autre selon les variations de pas.

Ces déplacements symétriques sont commandés, dans l'exemple illustré, au moyen de petits moteurs électriques 10 fixés dans le boîtier 8 . L'axe 10a des moteurs entraîne une portée filetée 10b qui coopère avec l'alésage fileté d'un organe entraîneur 11 . Des doigts 11a de l'organe 11 , traversent des fentes 12a d'un manchon 12 à section carrée selon l'exemple illustré. Les extrémités des doigts 11a sont engagées dans des organes 13 et 14 montés coulissants autour du manchon 12 . Le coulissement est facilité par exemple au moyen de billes ou rouleaux 15 . Sur l'organe 13 , est fixé en 13a par soudure ou autrement, le tube creux hélicoïdal 4 dont les extrémités de la spire interrompue portent les branches 1 - 1a . Sur l'organe 14 est fixé en 14a par soudure ou autrement, le tube creux hélicoïdal 6 , dont les extrémités de la spire interrompue portent les branches 3 - 3a .

Lorsque les moteurs 10 sont entraînés dans un sens ou dans l'autre, ils commandent le coulissement des organes 13 - 14 en éloignant ou en rapprochant les paires de branches 1 - 1a et 3 - 3a de la paire de branches médianes 2 - 2a . Les fentes 12a sont prévues pour autoriser ces déplacements.

On peut modifier ainsi, pendant le transfert des plaquettes, le pas, c'est-à-dire les intervalles qui les séparent. Un ou des capteurs de contacts tels que 16 , opérant dans les deux sens, pour entraîner les moteurs ou les arrêter, assurent des déplacements très précis des paires de branches et des plaquettes transportées.

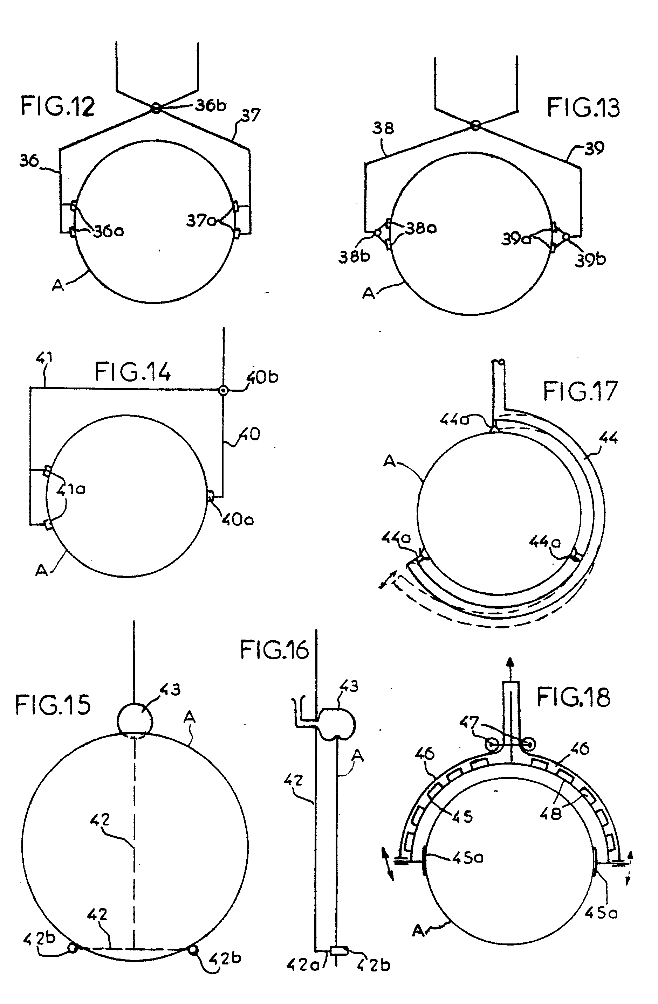

La forme de réalisation des figures 10 et 11 présente des moyens préhenseurs et porteurs à 5 paires de branches 17 - 17a -18 - 18a , 19 - 19a , 20 - 20a , 21 - 21a . Ce nombre n'est qu'un exemple non limitatif. Les paires de branches sont réalisées et fixées sur autant de tubes creux 22 - 23 - 24 - 25 - 26 - ayant une capacité de déformation élastique (du type Bourdon), les branches de chaque paire étant fixées aux extrémités d'une spire interrompue que présente chaque tube.

Il n'y a pas lieu de développer à nouveau ces dispositions qui sont semblables à celles qui sont illustrées aux figures 8 et 9 et que l'on a décrites.

Il en va de même en ce qui concerne une partie des moyens modificateurs des intervalles entre les paires de branches. Le tube médian 24 est fixé au boîtier, et il porte les branches 19 - 19a . De part et d'autre, les tubes 22 - 23 et 25 - 26 sont fixés respectivement aux organes 27 - 28 et 29 30 coulissant autour d'un manchon 31 dans lequel sont fixés les moteurs électriques 32 (un seul moteur est visible dans la figure 10 qui est une coupe pour une demi-partie). Sur les arbres 32a des moteurs, sont en appui des trains de galets de friction 33a et 34a visibles dans la demi-partie en coupe de la figure 10. Ces galets sont solidaires, respectivement, des organes entraîneurs 33 et 34 , avec des prolongements périphériques 33b et 34b engagés dans les organes 27 et 28 . Des dispositions symétriques existent pour l'autre demi-partie de la figure 10.

Les trains de galets de friction 33a et 34a présentent la particularité d'être montés tournant sur des axes inclinés par rapport à l'arbre 32a du moteur. Les galets en friction se trouvent donc inclinés et, selon un effet connu en soi, lorsque l'arbre 32a est entraîné en rotation, une force composante est appliquée qui déplace axialement les galets, les organes 27 - 28 avec les tubes et les paires de branches 17 -17a et 18 - 18a correspondantes. La valeur de ce déplacement dans le sens axial varie notamment selon l'inclinaison des galets pour un même déplacement angulaire de l'arbre 32a . On peut donc régler les variations d'intervalles et de pas. Un ou des capteurs de contacts, tel que 35 , contrôlent dans les deux sens les déplacements très précis des branches et des plaquettes.

Dans le cadre de l'invention sont prévues d'autres formes de réalisations des moyens préhenseurs agissant sur la tranche des plaquettes.

On voit à la figure 12, deux branches 36 - 37 croisées et articulées en 36b , dont les extrémités inférieures présentent chacune deux parties de contact 36a et 37a , agencées pour l'appui, le positionnement et le maintien contre la tranche des plaquettes A . A la figure 13, les branches 38 et 39 sont articulées et croisées de manière analogue et leurs extrémités inférieures présentent chacune deux parties de contact 38a et 39a qui sont articulées librement en 38b - 39b à l'extrémité inférieure des branches.

Les branches 40 - 41 de la figure 14 sont dissymétriques et articulées en 40b . L'extrémité inférieure de la branche 40 présente en 40a une partie de contact et de positionnement sur la tranche des plaquettes. La branche 41 qui a une forme générale en équerre, présente à son extrémité inférieure, deux parties 41a de contact et de positionnement.

Dans la réalisation schématiquement illustrée aux figures 15 et 16, les moyens préhenseurs sur tranche sont constitués par un bras vertical 42 articulé ou non, dont l'extrémité inférieure porte un bras transversal 42a aux extrémités duquel se trouvent des parties de contact 42b destinées à donner appui aux parties inférieures des plaquettes et à les positionner. Le bras 42 porte en outre un moyen d'appui sous forme d'une enveloppe gonflable 43 du type pneumatique qui peut agir et maintenir en pression radiale la tranche d'une plaquette A , lorsqu'un fluide gazeux est envoyé en pression dans l'enveloppe 43 , ou bien libérer la plaquette lorsque l'enveloppe est décomprimée.

Le moyen préhenseur illustré à la figure 17 est un tube creux 44 ayant une capacité de déformation élastique (du type BOURDON), qui peut entourer une ou des plaquettes sur un secteur circulaire étendu et qui porte, du côté de la tranche des plaquettes, des parties 44a de contact et de positionnement sur la tranche des dites plaquettes, comme illustré, lorsqu'aucun fluide de pression n'est envoyé dans le tube. Lorsqu'un fluide en pression est envoyé dans le tube 44 , ce dernier est ouvert élastiquement comme illustré en traits interrompus, et la ou les plaquettes sont libérées.

Selon la réalisation de la figure 18, le moyen préhenseur est constitué par une lame ou moyen élastiquement flexible 45 qui entoure partiellement les plaquettes sur un large secteur circulaire. Aux extrémités du moyen 45 se trouvent des parties 45a de contact et de maintien sur tranche des plaquettes. A ces extrémités sont attachés des câbles de tension 46 renvoyés sur des poulies 47 , et qui peuvent subir des efforts de traction selon flèche. Les câbles prennent appui sur des patins 48 ou moyens d'appui montés sui le dos du moyen flexible 45 . Un effort de traction sur les câbles écarte les parties 45a et libère la ou les plaquettes. Lorsque cet effort cesse, les plaquettes sont serrées sur tranche.

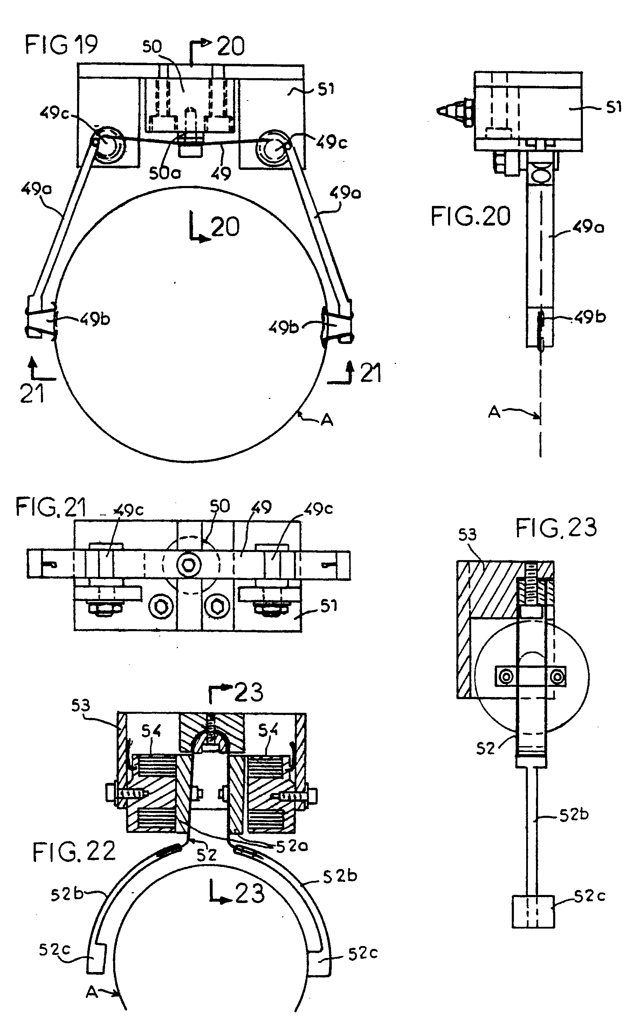

Les figures 19, 20 et 21 illustrent une réalisation des moyens préhenseurs selon laquelle la préhension s'opère par déformation, sans aucun frottement susceptible de polluer les plaquettes. Une lame-ressort 49 de section convenable prend appui sur des portées 49c . Les extrémités de cette lame sont solidaires de bras 49a dont l'extrémité libre porte un ou des patins 49b de contact et de positionnement sur la tranche d'une ou des plaquettes A . Un vérin 50 est fixé au support 51 qui porte la lame et les bras. La tige 50a de poussée du vérin a un déplacement réglable avec précision. Cette tige coopère avec la lame 49 . On comprend que la flexion dirigée vers le bas de la lame, sous la poussée du vérin, fait pivoter les bras 49a pour les écarter de la ou des plaquettes, en libérant ces dernières. A l'inverse, en cessant la poussée du vérin, la lame revient à la position initiale et les bras pivotent en assurant la préhension sur la tranche de la ou des plaquettes.

Dans la réalisation des moyens préhenseurs selon les figures 22 et 23, un ressort à lame 52 en forme de U renversé est fixé par sa partie coudée à un support 53 . Sur les branches de la lame sont fixées des plaques 52a destinées à subir la force d'attraction magnétique des électro-aimants 54 qui sont fixés au support 53 . Les extrémités de la lame 52 sont solidaires de bras en arc 52b terminés par des patins 52c ou parties de contact et de positionnement sur la tranche d'une ou de plaquettes A . Lorsque les électro-aimants sont sous tension, l'effet d'attraction pivote la lame et les bras, en écartant les patins 52c de la ou des plaquettes qui sont libérées, ce qui est illustré par une demi-partie de la figure 22. Lorsque les électro-aimants ne sont pas en action, la lame élastique et les bras se placent en position de préhension sur la tranche de la ou des plaquettes, comme cela est illustré dans l'autre demi-partie de la figure 22.

La réalisation des moyens préhenseurs selon les figures 24 et 25 est également du type fonctionnant par déformation. Le ressort à lame 55 est déformé par une pression pneumatique obtenue en envoyant un fluide gazeux sous pression dans une enveloppe 56 qui peut être un soufflet métallique à ondulations dont le fond 56a coopère avec la lame 55 . Les extrémités de la lame sont fixées au support 57 par l'intermédiaire de plots élastiques 58 déformables en suivant les déformations de la lame. Les plots 58 sont montés sur un support 59 qui porte le système de pression à soufflet. Les extrémités de la lame 55 sont solidaires de bras 55a terminés par des patins 55b ou parties de contact et de positionnement sur la tranche d'une ou de plaquettes A . L'on conçoit que, selon la déformation de la lame commandée par le système de pression, ou la position rectiligne de la lame en l'absence de pression, les plaquettes sont libérées par l'écartement des patins, ou bien les plaquettes sont prises par serrage sur leur tranche.

D'une manière particulièrement avantageuse, on souligne que chacun des moyens de préhension, quelle que soit sa forme de réalisation, est assujetti à un moyen de commande indépendant de sorte que l'on peut prendre à volonté, soit une seule plaquette, soit la totalité, soit un nombre quelconque prédéterminé.

Concernant le procédé de l'invention suivant lequel on opère automatiquement le cycle : approche du four (B), transfert des plaquettes (A) dans les nacelles (D), enfournement, défournement, transfert des plaquettes (A) dans les paniers (C), et éloignement du four, on a illustré schématiquement à la figure 26, dans leur ensemble, et à titre d'exemple de réalisation, les moyens essentiels de mise en oeuvre.

Les paniers (C) de plaquettes (A) qui ont subi l'opération précédente de traitement, sont montés chacun sur un support (60) qui est déplacé avec le panier (C), le long d'une voie ou de moyens de guidage. Dans l'exemple illustré, il s'agit de tiges de guidage (61). Le panier et le support sont déplacés selon flèches F, par exemple au moyen de vérins pneumatiques, hydrauliques, non représentés, mais que le technicien met en oeuvre sans difficulté particulière. Ces moyens doivent permettre des déplacements réguliers et sans à-coups. On peut utiliser des moyens mécaniques (chaîne, crémaillère, ...) susceptibles d'assurer les déplacements dans les mêmes conditions. Un contacteur non représenté mais dont la mise en oeuvre est aisée, assure l'arrêt précis du support (60) et du panier (C).

Cette position d'arrêt se trouve à proximité d'une nacelle (D) vide, portée et maintenue par des moyens enfourneurs qui sont, selon l'exemple illustré, des tiges (62) dont la tête (62a) peut recevoir la poussée, selon flèches F1, de moyens de poussée ou d'entraînement tels que vérins, systèmes mécaniques à chaîne, crémaillère, ..., logés dans le boîtier longitudinal (62b). Les tiges (62) sont en face de l'entrée d'un compartiment du four (B), par exemple le compartiment (B1).

Dans l'exemple illustré, le panier (C) est amené parallèlement à la nacelle (D) et près de cette nacelle.

Parallèlement aux tiges (61), est montée une barre (63) le long de laquelle peut être déplacé ou se déplace, selon les flèches F2, un ensemble figuré schématiquement en (64). Cet ensemble est déplacé par tout système de vérin, ou des moyens mécaniques à chaîne ou autre. L'ensemble (64) porte un bras transversal (65) sur lequel peut être déplacé selon flèches F3, un boîtier (66) portant le ou les moyens préhenseurs des plaquettes, et modificateurs de pas ou intervalles entre les plaquettes. Le boîtier (66) peut être par exemple le boîtier (8) du dispositif illustré aux figures 8 et 9, ou le boîtier du dispositif des figures 10 et 11.

Des contacteurs non représentés pour la clarté du dessin, mais que l'on peut mettre en oeuvre sans difficulté, limitent et fixent avec précision, dans les deux sens, les déplacements de l'ensemble (64) et du boîtier (66).

On voit plus précisément dans les schémas des figures 4 et 5, des moyens de poussée de bas en haut des plaquettes (A) contenues dans les paniers (C). Ces moyens connus en eux-mêmes, comprennent un support (E) avec des encoches ou entailles qui prennent appui sous les plaquettes des paniers en les maintenant en position selon les intervalles ou pas. Le support (E) reçoit la poussée d'un vérin (E1) qui est commandé judicieusement en synchronisme avec les autres déplacements.

Le système (E - E1) de poussée des plaquettes contenues dans les paniers (C) est visible succinctement à la figure 26.

A l'aide des moyens décrits, on opère donc d'une manière entièrement automatique, sans aucune intervention manuelle, les déplacements des plaquettes (A) dans les paniers (C) afin de les amener au-dessus des moyens de poussée (E - E1) et à proximité de la nacelle (D) en attente. On opère le transfert des plaquettes (A) jusqu'à la nacelle (D) en modifiant le pas ou intervalles entre lesdites plaquettes, en opérant autant de déplacements transversaux selon les flèches F3 qu'il est nécessaire. On enfourne la nacelle (D) et les plaquettes (A) selon flèche F1 dans le compartiment (B1) du four (B).

Après le traitement thermique, on défourne la nacelle et les plaquettes en les déplaçant avec les tiges (62) en sens inverse des flèches F1. On opère le transfert des plaquettes (A) avec modification de leur pas ou intervalles, jusqu'au panier (C) en attente. Lorsque le panier (C) est entièrement chargé de plaquettes, il est entraîné par son support (60) selon flèche F2, puis transversalement selon flèche F4 et longitudinalement selon flèche (F5) jusqu'à un poste suivant de traitement des plaquettes. Les déplacements selon les flèches (F4 - F5) s'opèrent à l'aide de tout moyen ou système connu, par vérin, moyens mécaniques à chaîne, à crémaillère....

Il est évident que des moyens de contacts et de positionnement précis sont prévus dans les diverses phases des déplacements décrits. De même, des commandes synchronisées sont mises en oeuvre afin d'ordonner et d'effectuer ces déplacements. On ne les a pas représenté à la figure 26 pour la clarté du dessin.

Les moyens et l'installation qui sont illustrés à la figure 26, peuvent se trouver à chacun des niveaux, en face des compartiments (B1 - B2 - B3 ....) du four. Ces moyens et cette installation pourraient être montés sur un support d'ensemble et déplacés verticalement pour être amenés aux divers niveaux, ou transversalement.

## Revendications

1. Procédé pour la préhension et le transport des plaquettes de silicium entre un premier support sous forme d'un panier (C) et un deuxième support sous forme d'une nacelle (D), les plaquettes (A) étant supportées verticalement par leurs bords, par des encoches espacées que présentent ledit panier et ladite nacelle, les encoches du panier et les encoches de la nacelle pouvant avoir un écartement different, ledit procédé comportant les étapes suivantes :
   - on met en action des moyens (E - E1) pour pousser de bas en haut lesdites plaquettes et les dégager des encoches du panier (C) de façon à les rendre accessibles aux moyens préhenseurs ;
   - on met en oeuvre des moyens porteurs et préhenseurs (1, 1a, 2, 2a) qui entourent partiellement les plaquettes de silicium par la tranche ;
   - on agit sur les moyens préhenseurs afin d'amener leurs parties de préhension en appui et en serrage radial ou sensiblement contre la tranche des plaquettes ;
   - on déplace l'ensemble des plaquettes en direction de la nacelle (D) et on agit sur les moyens porteurs et préhenseurs (1, 1a, 2, 2a) pour faire varier l'écartement entre lesdites plaquettes et les mettre en correspondance avec le pas des encoches de la nacelle (D) ;
   - on abaisse les moyens porteurs et préhenseurs pour positionner les plaquettes dans les encoches de la nacelle (D).

2. Procédé selon la revendication 1, caractérisé en ce que l'on amène les parties d'appui des moyens préhenseurs (E - E1) qui présentent des moyens de positionnement pour la ou les plaquettes en appui de simple retenue par l'effet de gravité, contre la tranche de la ou des plaquettes (A) en un ou plusieurs points de leur partie périphérique inférieure.

3. Procédé suivant la revendication 1, caractérisé en ce que l'on opère automatiquement le cycle : approche du four (B), transfert, enfournement, defournement, transfert et éloignement du four, et, pour cela, on déplace le support de chaque panier (C) porte-plaquette le long d'un moyen ou voie de guidage, jusqu'à proximité de l'entrée du four (B) ou d'un compartiment du four, on fait agir les moyens (E - E1) de poussée de bas en haut sur les plaquettes du panier, puis les moyens préhenseurs que l'on déplace avec une ou des plaquettes en même temps qu'on réduit le pas ou intervalles entre lesdites plaquettes ; on dépose les plaquettes dans une nacelle (D) en quartz, montée sur un support mobile guidé longitudinalement en face de l'entrée du four ou du compartiment, et, lorsque la nacelle est garnie de plaquettes, on enfourne ladite nacelle d'une manière régulière et automatique ; après l'action thermique dans le four, on défourne la nacelle et les plaquettes au moyen du support mobile, d'une manière régulière et automatique, puis on saisit les plaquetts à l'aide des moyens préhenseurs, on déplace les moyens préhenseurs avec les plaquettes en même temps qu'on augmente le pas ou intervalles entre les plaquettes, et on dépose les plaquettes dans un panier dont le support est guidé longitudinalement. pour l'éloigner du four en direction de l'opération suivante du traitement.

4. Moyen de mise en oeuvre du procédé suivant l' une quelconque des revendications 1 à 3, caractérisé en ce que les moyens préhenseurs sont constitués par des paires de tiges ou branches enveloppantes (1, 1a, 2, 2a) dont les extrémités libres présentent des parties d'appui et de maintien sur tranche des plaquettes, les branches de chaque paire étant fixées aux extrémités d'une spire interrompue de tubes creux hélicoïdaux (4, 5, 6) et à capacité de déformation élastique, en nombre correspondant au nombre de paires de branches, les tubes creux ont un système d'alimentation en fluide gazeux que l'on met en pression lorsqu'on veut écarter les branches et un système de modification des intervalles entre les paires de branches.

5. Moyen suivant la revendication 4, caractérisé en ce que l'on peut modifier les intervalles entre les paires de branches en donnant au tube médian (5) et à la paire de branches (2, 2a) correspondante, une position médiane longitudinale fixe par rapport au boîtier-support (8) de l'ensemble ; de part et d'autre, les tubes et leurs paires de branches correspondantes peuvent être déplacés symétriquement en étant solidaires chacun d'organes-supports (13, 14) coulissant sur un manchon (12) dans lequel sont montés des moteurs électriques (10) d'entraînement longitudinal des organes-supports (13 - 14) par système à vis et doigts d'entraînement guidés dans des fentes (12a) du manchon (12) ; des capteurs de contact (16) assurant les déplacements et arrêts aux positions précises des paires de branches.

6. Moyen suivant la revendication 4, caractérisé en ce que, pour modifier les intervalles entre les paires de branches se trouvant de part et d'autre du tube médian (24) et de la paire de branches (19 - 19a) fixes dans la position longitudinale médiane par rapport au boîtier-support de l'ensemble, on fait agir des moteurs électriques (32) sur les arbres (32a) desquels sont en appui des trains de galets de friction (33a - 34a) dont les axes sont inclinés par rapport à l'arbre (32a) des moteurs, ces galets étant solidaires d'organes entraîneurs (33 - 34) dont les prolongements périphériques (33b - 34b) sont solidaires des organes-supports des tubes et paires de branches, lesdits organes-supports (33 - 34) coulissant sur le manchon (31) portant les moteurs électriques ; les différences d'inclinaison des galets de friction permettant de régler la valeur des déplacements dans le sens axial des tubes et paires de branches.

7. Moyen suivant la revendication 4, caractérisé en ce que les branches de préhension (36 - 37) des moyens préhenseurs sont croisées et articulées (36b), leurs extrémités inférieures présentant chacune deux parties de contact sur tranche contre les plaquettes.

8. Moyen suivant la revendication 4, caractérisé en ce que les branches de préhension (38 - 39) des moyens préhenseurs sont croisées et articulées, et leurs extremités inférieures présentent chacune deux parties de contact (38a - 39a) articulées librement (38b - 39b).

9. Moyen suivant la revendication 4, caractérisé en ce que les branches (40 - 41) des moyens préhenseurs sont dissymétriques et articulées (40b), l'extrémité d'une branche (40) présentant une partie de contact et de positionnement, l'autre branche (41) qui a une forme générale en équerre, présentant une extrémité inférieure avec deux parties (41a) de contact et de positionnement sur la tranche des plaquettes.

10. Moyen suivant la revendication 4, caractérisé en ce que le moyen préhenseurs présente un bras vertical (42) dont l'extrémité inférieure présente un bras transversal avec des parties de contact (42b) donnant appui aux parties inférieures des plaquettes, le bras vertical (42) portant aussi un moyen d'appui sur la tranche, sous forme d'une enveloppe gonflable (43).

11. Moyen suivant la revendication 4, caractérisé en ce que le moyen préhenseur est constitué par un tube creux (44) ayant une cpacité de déformation elastique, qui entoure les plaquettes sur un secteur circulaire étendu et qui porte, du côté de la tranche des plaquettes, des parties (44a) de contact et de positionnement.

12. Moyen suivant la revendication 4, caractérisé en ce que le moyen préhenseur constitué par une lame flexible (45) qui entoure partiellement les plaquettes sur un large secteur circulaire, les extrémités de la lame présentant des parties de contact (45a), et ladite lame étant équipée de câbles (46) avec poulies de renvoi et patins d'appui.

13. Moyen suivant la revendication 4, caractérisé en ce que le moyen préhenseur constitué par une lame-ressort (49) prenant appui sur des portées (49c) et dont les extréités sont solidaires de bras (49a) portant un ou des patins de contact et de positionnent sur la tranche des plaquettes, un vérin (50) agissant pour mettre la lame en flexion afin de pivoter les bras.

14. Moyen suivant la revendication 4, caractérisé en ce que le moyen préhenseur est constitue par une lame-ressort (52) en forme de U renversé, fixé à un support, les extrémités de lame sont solidaires de bras (52b) portant des patins (52c) de contact ; des électro-aimants (54) fixés à un support (53) agissant sur des plaques (52a) fixées aux branches de la lame (52) afin de les pivoter avec les bras et les patins lorsque les électroaimants sont mis sous tension.

15. Moyen suivant la revendication 4, caractérisé en ce que le moyen préhenseur est constitué par un ressort à lame (55) fixé sur des plots élastiques (58) déformables, le extrémités de la lame étant solidaires de bras (55a) portant des patins (55b) de contact sur la tranche des plaquettes, la lame pouvant être déformée en pivotant les bras et patins, au moyen d'une pression pneumatique exercée en envoyant un fluide gazeux sous pression dans une enveloppe déformable (56) tel qu'un soufflet métallique.

16. Moyen selon la revendication 4, et l'une quelconque des revendications 7 à 15, caractérisé en ce que chacun des moyens préhenseurs est asservi à un moyen de commande indépendant.

17. Moyen de mise en oeuvre du procédé suivant l'une quelconque des revendications 1 à 3, caractérisé en ce que les paniers (C) portant les plaquettes (A) sont montés sur un support (60) qui est déplacé le long d'une voie ou de moyens de guidage, par des moyens tels que vérins pneumatiques, hydrauliques ou des moyens mécaniques à chaîne, crémaillère ou autre ; un contacteur assure une position précise d'arrêt du support et du panier à proximité d'une nacelle (D) vide portée par des moyens enfourneurs ; lesdits moyens enfourneurs pouvant être des tiges supports déplacées avec la nacelle par des moyens tels que vérins, systèmes mécaniques, afin d'opérer l'enfournement puis ensuite le défournement ; le long d'une barre ou moyen équivalent de guidage peut être déplacé, avec précision, avec des contacteurs d'arrêt, au moyen de tout système de vérins ou moyens mécaniques, un ensemble (64) portant un bras transversal (65) sur lequel peut être déplacé au moyen de vérins ou moyens mécaniques, d'une manière précise par des contacteurs d'arrêt, le ou les moyens préhenseurs des plaquettes et les moyens modificateurs du pas ou intervalles entre les plaquettes ; le dispositif de poussée (E - E1) de bas en haut, sous les plaquettes, se trouve audessous de l'emplacement d'arrêt du support (60) et du panier (c) ; des moyens permettant et assurant le guidage et le déplacement transversal du support (60) et du panier (c), puis leur guidage et déplacement transversal jusqu' au poste suivant de traitement des plaquettes, ces déplacement étant commandés par vérins et/ou moyens mécaniques ; des moyens de contact et de positionnement précis étant prévus dans les diverses phases des déplacements, et des commandes étant mises en oeuvre pour assurer les déplacements synchronisés.

## Claims

1. Method for gripping and transporting small plates of silicon between a first support in the form of a basket (C) and a second support in the form of a nacelle (D), the small plates (A) being supports vertically at the edges thereof by spaced notches with which said basket and said nacelle are provided, with the possibility of a different spacing between the notches of the basket and between the notches of the nacelle, said method comprising the following steps :
   - means (E - E1) are actuated to urge said small plates upwardly in order to disengage them from the notches of the basket (C), so that they will be within reach of the gripping means ;
   - carrying and gripping means are provided (1, 1a ; 2, 2a) for surrounding in part the small plate of silicon at the cut edge thereof ;
   - the gripping means are acted upon in order to bring their gripping portions in a position of abutment and of radial or approximately radial tightening against the cut edges of the small plates ;
   - the entirety of the small plates is moved in the direction of the nacelle (D) and the carrying and gripping means (1, 1a ; 2, 2a) are acted upon in order to vary the spacing between said small plates and to bring them in coincidence with the pitch of the notches of the nacelle (D) ;
   - the carrying and gripping means are lowered in order to position the small plates in the notches of the nacelle (D).

2. Method as claimed in Claim 1, characterized in that the abutment portions of the gripping means (E - E1), which include positioning means for the small plate or small plates are brought to a position of mere retaining abutment by the effect of gravity against the cut edge of the small plate or plates (A) in one or more points of the lower peripheral portions thereof.

3. Method as claimed in Claim 1, characterized in that the cycle including : approach to the furnace (B), transfer, charging, unloading, transfer and removal from the furnace is operated automatically, and for this purpose the support of each plate-holding basket (C) is moved along a guide means or way up to a position adjacent the entry of the furnace (B) or a compartment of this furnace while actuating the means (E-E1) for urging upwardly the small plates of the basket, and then the gripping means which are moved together with one or more small plates at the same time as the pitch or spacing between said plates is decreased, the plates being placed in a nacelle of quartz (D) mounted on a movable support guided longitudinally in front of the furnace or of the furnace compartment, and the nacelle, when same is provided with plates, being charged into the furnace in a regular and automatic manner, whereby after the heat treatment in the furnace, the nacelle and the plates are taken out of the furnace by means of the movable support, in a regular and automatic manner, the plates being then gripped by the gripping means and said gripping means being moved along together with the plates at the same time as the pitch or spacing between the small plates is increased, the plates being placed in a basket the support of which is guided longitudinally in order to take this basket away from the furnace in the direction of the next step of treatment.

4. Means for carrying out the method claimed in any one of Claims 1 to 5, characterized in that the gripping means consist of pairs of enclosing rods or arms (1, 1a, 2, 2a) the free ends of which are provided with portions for abutting and holding the plates along the cut edge, the arms of each pair being secured to the ends of an interrupted tour of helical hollow tubes (4, 5, 6) with a capacity of elastic deformation, in a number corresponding to the number of the arm pairs, the hollow tubes having a supply system of gazeous fluid that is set under pressure when it is desired for the arms to be spaced apart, and a system for modifying the spacing between the arm pairs.

5. Means as claimed in Claim 4, characterized in that it is possible to modify the spacing between the arm pairs by imparting to the medial tube (5) and to the corresponding pair of arms (2, 2a) a fixed longitudinal medial position relative to the support-casing (8) of the unit, whereby the tubes and their corresponding pairs of arms can be shifted symmetrically on either side while being dependent each one from supporting organs (13, 14) moving slidably on a sleeve (12) within which are mounted the electric motors (10) for driving longitudinally the supporting organs (13 - 14) by means of a system of screw and driving fingers guided in slots (12a) of sleeve (12), contact sensors (16) providing the movements and the stops at accurate positions of the pairs of arms.

6. Means as claimed in Claim 4, characterized in that the modification of the spacing between the pairs of arms located on either side of the medial tube (24) and of the pair of arms (19 - 19a) secured in the longitudinal medial position relative to the support-casing of the unit, is provided by actuating electric motors (32) on shafts (32a) which are abutted by frictional roller harnesses (33a - 34a) the center lines of which are inclined relative the shaft (32a) of the motors, said rollers being dependent from driving organs (33 - 34) the peripheral extensions (22b - 34b) of which are dependent from the supporting organs of the tubes and arm pairs, said supporting organs (33 - 34) being moved slidably on the sleeve (31) upon which the electric motors are supported, the differences of inclination of the frictional rollers permitting to adjust the amount of the shifting in the axial direction of the tubes and arm pairs.

7. Means as claimed in Claim 4, characterized in that the gripping arms (36 è 37) of the gripping means are crossed and linked hingedly, (36b), the lower ends of which having each one two portions for the contact on cut edge against the small plates.

8. Means as claimed in Claim 4, characterized in that the gripping arms (38 - 39) of the gripping means are crossed and linked hingedly, and that the lower ends thereof have each one two contact portions (38a - 39a) which are freely articulated (38b)-(39b).

9. Means as claimed in Claim 4, characterized in that the arms (40 - 41) of the gripping means are non symmetrical and linked hingedly (40b), the end of an arm (40) having a contact and positioning portion, the other arm (41) having a generally squared shape and a lower end provided with two portions (41a) for contact and positioning on the cut edge of the small plates.

10. Means as claimed in Claim 4, characterized in that the gripping means has a vertical arm (42) the lower end of which has a cross arm with contact portions (42b) for the abutment of the lower portions of the small plates, the vertical arm (42) supporting also a means for abutment on the cut edge in the form of an inflatable covering (43).

11. Means as claimed in Claim 4, characterized in the gripping means consists of a hollow tube (44) which can be distorted elastically, and surrounds the small plates along an extended circular sector, while supporting on the side of the cut edge of the plates the contact and positioning portions (44a).

12. Means as claimed in Claim 4, characterized in that the gripping means consists of a flexible blade (45) surrounding in part the small plates along a large circular sector, the ends of the blade being provided with contact portions (45a), and said blade being equipped with idle pulleys and abutment shoes.

13. Means as claimed in Claim 4, characterized in that the gripping means consists of a spring-blade (49) abutted on bearing faces (49c) the ends of which are dependent from arms (49a) and support one or more contact and positioning shoes for the cut edge of the small plates, a pressure cylinder (50) being actuated to flex the arm in order to cause the arms to be pivoted.

14. Means as claimed in Claim 4, characterized in that the gripping means consists of a spring-blade (52) in the form of an inverted U, which is secured to a support, the ends of the blade being dependent from arms (52b) which support contact shoes (52c), the plates (52a) secured to the arms of the blade (52) being subjected to the action of electromagnets (54) secured to a support (53), so that said plates will be pivoted together with the arms and the shoes when voltage is applied to the electromagnets.

15. Means as claimed in Claim 4, characterized in that the gripping means consists of a spring controlled blade (55) secured to elastic and deformable plugs (58), the ends of the blade being dependent from arms (55a) which support the shoes (55b) for the contact on the cut edge of the small plates, whereby the blade can be distorted while causing the arms and shoes to be pivoted by means of air pressure applied through sending a gazeous fluid under pressure into a deformable covering (56) such as bellows means of metal.

16. Means as claimed in Claim 4 and in any one of Claims 7 through 15, characterized in that each one of the gripping means is monitored by an independent control means.

17. Means for carrying out the method in accordance with any one of Claims 1 through 3, characterized in that the baskets (C) supporting the small plates (A) are mounted on a support (60) which is moved along a way or guiding means by using means such as air pressure cylinders, hydraulically operated cylinders, or mechanical chain means as racks or the like, a contactor providing an accurate stop position for the support and the basket adjacent an empty nacelle (D) supported by furnace charging means, whereby said furnace charging means can be supporting rods moved together with the nacelle by the use of means such as pressure cylinders, mechanical systems, in order to operate the charging into the furnace and then the removal from the furnace, and there may be moved with accuracy, with stop contactors and by means of any system of pressure cylinders or mechanical means, along a bar or equivalent guide means, a unit (64) supporting a cross arm (65) upon which can be moved by means of pressure cylinders or mechanical devices, in an accurate manner by stop contactors, the gripping system or systems for the small plates and the modifying means for the pitch or spacing between the plates, the upward urging device (E - E1), under the small plates, being located underneath the stopping point of the support (60) and of the basket (C), means being provided to permit and to cause the aiding and the transverse shifting of the support (60) and of the basket (C), and then the transverse guiding and shifting thereof up to the next station of treatment for the small plates, these movements being controlled by cylinders and/or mechanical devices, while accurate positioning and contact means are provided along the various steps of these shiftings, and control means are operated for the synchronization of the movements.

## Ansprüche

1. Verfahren zum Greifen und Transportieren von Siliziumplättchen zwischen einem ersten korbförmigen Träger (c) und einem zweiten nachenförmigen Träger (D), mit den besagten Plättchen durch deren Ränder und durch abstehende Einkerbungen vertikal abgestützt, die der genannte Kerb und der genannte Nacken aufweisen, wobei wobei die Einkerbungen des Korbs und die Einkerbungen des Nachens mit unterschiedlichen Abständen vorgesehen werden können, und das besagte Verfahren die folgenden Arbeitsvorgänge umfasst :

- Vorrichtungen (E - E1) zum Vorschieben der besagten Plättchen nach oben und zum Freimachen derselben aus den Einkerbungen des Korbs (c) werden betätigt, damit die Plättchen für die Greifermittel zugänglich werden ;
- Träger- und Greifermittel (1, 1a ; 2, 2a) werden bewerkstelligt, die die Siliziumplättchen gemäss der Schnittkante derselben teilweise einschliessen ;
- die Greifermittel werden so betätigt, dass ihre Greiferteile zum Abstützen und radialen oder ungefahr radialen Festziehen gegen die Schnittkante der Plättchen kommen ;
- die gesamten Plättchen werden in Richtung nach dem Nacken (D) verschoben, und die Träger- und Greifermittel (1, 1a ; 2, 2a) werden betätigt, damit der Abstand zwischen den besagten Plättchen verändert wird, wobei die Plättchen entsprechend der Teilung der Einkerbungen des Nachens (D) eingerichtet werden ;
- die Träger- und Greifermittel werden zum Positionieren der Plättchen in die Einkerbungen des Nachens niedersenkt.

2. Verfahren nach Anspruch 1, dadurch gekennzeichnet, dass die die Positionierungsmittel für das oder die Plättchen aufweisenden Abstützungsteile der Greifermittel (E - E1) zum Abstützen mit einfacher Aufhaltekraft infolge der Wirkung der Schwere gegen die Schnittkante des oder der Plättchen auf verschieden Punkten dessen oder deren peripherischen Unterteils gebracht werden.

3. Verfahren nach Anspruch 1, dadurch gekennzeichnet, dass die zyklische Arbeitsfolge : Annähern zum Ofen (B), Verlegung, Beschickung, Herausnehmen aus dem Ofen, Verlegung und Wegnahme von dem Ofen automatisch durchgeführt wird, und für diesen Zweck wird der Träger jedes Plättchenhalterkorbs (c) an einem Führungsmittel oder an einer Führungsbahn entlang bis nähe zum Eingang des Ofens (B) oder nähe zu einer Abteilung des Ofens geführt, indem die Vorrichtungen (E - E1) zum Vorschieben der plättchen des Korbs nach oben und dann die bei gleichzeitiger Verminderung der Teilung oder Abstände zwischen den Plättchen verlagerten Greifermittel mit einem oder mehreren Plättchen betätigt werden ; dass die Plättchen in einen, auf einen beweglichen, der Länge nach vor dem Eingang des Ofens oder der Ofenabteilung geführten Träger montierten Nachen (D) aus Quarz gebracht werden, und der besagte Nachen, nachdem derselbe mit Plättchen beladen ist, in den Ofen regelmässig und automatisch beschickt wird ; und dass der Nachen mit den Plättchen, nach der Wärmebehandlung in dem Ofen, aus dem Ofen mittels des beweglichen Trägers regelmässig und automatisch entladen werden, wobei die Plättchen mittels der Greifervorrichtungen erfasst werden die dann zusammen mit den Plättchen gleichzeitig mit der Steigerung der Teilung oder der Abstände zwischen den Plättchen fortbewegt werden, damit die Plättchen in einen Korb gebracht werden können, dessen Träger längsweise zum Entfernen dieses Trägers weg von dem Ofen und in Richtung nach der nächsten Behandlungsstelle geführt wird.

4. Ausführungsart zum Bewerkstelligen des Verfahrens nach einem der vorhergehenden Ansprüche 1 bis 3, dadurch gekennzeichnet, dass die Greifermittel aus Paaren von umfassenden Stangen oder Schenkeln (1, 1a, 2, 2a) bestehen, derer oder deren freie Enden Abstützungs- und Halteteile gemäss der Schnittkante der Plättchen aufweisen, und dass die Schenkel jedes Paars auf den Enden einer unterbrochenen Windung von elastisch verformbaren, schraubenförmigen ausgehöhlten Röhren (4, 5, 6) befestigt sind, derer Zahl der Zahl der Schenkelpaare entspricht, wobei die ausgehöhlten Röhren ein Zuführungssystem für gasförmige Flüssigkeit aufweisen, das unter Druck gesetzt wird, wenn man wünscht, die Schenkel auseinanderzuspreizen, und hiebei weisen die besagten Röhren ein System zur Veränderung der Abstände zwischen den Schenkelpaaren auf.

5. Ausführungsart nach Anspruch 4, dadurch gekennzeichnet, dass die Abstände zwischen den Schenkelpaaren verändert werden können, indem man die mittige Röhre (5) und das entsprechende Schenkelpaar (2, 2a) eine längliche, mittige, feststehende Stellung mit Bezug auf das Halterungsgehäuse (8) einnehmen lässt, wobei die Röhren und ihre entsprechenden Schenkelpaare beiderseitig und symmetrisch verlagert werden können, indem jede eine dieser Röhren abhängig von Trägerorganen (13 - 14) sind, die auf eine Muffe (12) verschiebbar sind, in welcher die Elektromotoren (10) zum mitnehmen der Trägerorgane (13 - 14) in der Längsrichtung durch ein System von in den Schlitzen (12a) der Muffe (12) geführten Schrauben und Mitnahmefingern angeordnet sind, und Berührungsabtastevorrichtungen (16) die Verlagerungen und das Anhalten auf genau vorgesehenen Stellungen der Schenkelpaare bewirken.

6. Ausführungsart nach Anspruch 4, dadurch gekennzeichnet, dass zum Verändern der Abstände der beiderseitig der mittigen Röhre (24) befindlichen Schenkelpaare sowie des auf der mittigen länglichen Stellung in Bezug auf das Halterungsgehäuse der Gesamteinheit befestigten Schenkelpaars (19 - 19a) werden Elektromotoren (32) zum Einwirken auf die Wellen (32a) in Gang gesetzt, die die Reibungsrollensätze (33a - 34a) abstützen, derer Achsen in Bezug auf die Welle (32a) der Motoren geneigt sind, wobei diese Rollen von Mitnehmerorganen (33 - 34) abhängig sind, deren peripherische Verlängerungen (33b - 34b) wiederum von den Trägerorganen der Rohren und der Schenkelpaare abhängig sind, und dass die besagten Mitnehmerorgane (33 - 34) auf die die Eletromotoren tragende Muffe verschiebbar sind, wobei die Neigungsunterschiede der Reibungsrollen die Verstellung der Bewegungswerte in der Achsialrichtung der Röhren und der Schenkelpaare ermöglichen.

7. Ausführungsart bach Anspruch 4, dadurch gekennzeichnet, dass die Greiferschenkel (36 - 37) der Greifervorrichtungen gekreuzt und gelenkig (36) sind, und dass die unteren Enden jedes einen dieser Schenkel zwei. Teile zur Schnittkantenberührung gegen die Plättchen aufweisen.

8. Ausführungsart nach Anspruch 4, dadurch gekennzeichnet, dass die Greiferschenkel (38 - 39) der Greifervorrichtungen gekreuzt und gelenkig sind, und dass die unteren Enden jedes einen dieser Schenkel zwei frei-` gelenkigen (38b - 39b) Berührungsteile (38a - 39a) aufweisen.

9. Ausführungsart nache Anspruch 4, dadurch gekennzeichnet, dass die Schenkel (40 - 41) der Greifervorrichtungen unsymmetrisch und gelenkig (40b) sind, und dass das Ende eines Schenkels (40) einen Berührungsund Positionierungsteil aufweist, wobei der andere, in allgemeinen winkeleisenförmigen Schenkel (41) ein unteres Ende mit zwei Teilen (41a) zur Berührung und Positionierung auf die Schnittkante der Plättchen auch aufweist.

10. Ausführungsart nach Anspruch 4, dadurch gekennzeichnet, dass die Greifervorrichtung einen Vertikalarm (42) aufweist, dessen unteres Ende einen Querarm mit Berührungsteilen (42b) trägt, die die Unterteile der Plättchen abstützen, wobei der Vertikalarm (42) ein als eine anschwellbare Umhüllung (43) gestaltetes Mittel zur Abstützung auf die Schnittkante auch aufweist.

11. Ausführungsart nach Anspruch 4, dadurch gekennzeichnet, dass die Greifervorrichtung aus einer elastisch verformbaren, ausgehöhlten Röhre (44) besteht, die die Plättchen auf einem ausgedehnten kreisförmigen Sektor umfasst, und Berührungs- und Positionierungsteil (44a) nach der Seite der Schnittkante der Plättchen aufweist.

12. Ausführungsart nach Anspruch 4, dadurch gekennzeichnet, dass die Greifervorrichtung aus einem biegsamen Blatt (45) besteht, das die Plättchen auf einem umfangreichen kreisförmigen Sektor teilweise umfasst, wob die Enden des Blatts die Berührungsteile (45a) aufweise und das genannte Blatt mit Seilen (46) und Umlenkscheiben sowie Abstützungsschuhen versehen ist.

13. Ausführungsart nach Anspruch 4, dadurch gekennzeichnet, dass die Greifervorrichtung aus einem Federblatt (49) besteht, das auf Lägerflächen (49c) abgestützt ist, und dass die Enden dieses Federblatts von Armen (49a) Abhängig sind, die einen oder mehrere Schuhe zur Berührung aud Positionierung auf die Schnittkante der Plättchen tragen, wobei ein Druckzylinder (5o) zur Durchbiegung des Blatts und zum entsprechenden Verschwenken der Arme wirksam wird.

14. Ausführungsart nach Anspruch 4, dadurch, gekennzeichnet, dass die Greifervorrichtung aus einem ungekehrt U-förmigen Federblatt (52) besteht, das auf einem Träger befestigt ist, wobei die Blattenden von Armen (52b) abhängig sind, die die Berührungsschuhe (52c) tragen, und dass die-auf einem Träger (53) befestigten Elektromagneten (54) auf Platten (52a) wirken, die auf den Schenkeln des Blatts (52) befestigt sind, damit diese Platten zusammen mit den Armen und den Schuhen bei Spannungsanschluss der Elektromagneten verschwenkt werden.

15. Ausführungsart nach Anspruch 4, dadurch gekennzeichnet, dass die Greifervorrichtung aus einer auf den fendernden, verformbaren Kontaktstücken(58) befestigten Blattfeder (55) besteht, wobei die Enden dieser Blattfe der von Armen (55a) abhängig sind, die die Schuhe (55b) zur Berührung auf die Schnittkante der Plättchen tragen, und dass die Blattfeder zum Verschwenken der Arme und der Schuhe mittels eines Luftdrucks verformt werden kann, der durch Zuführung einer unter Druck stehenden gasförmigen Flüssigkeit in eine verformbare Umhüllung wie beispielsweise einen Blasebalg aus Metall ausgeübt wird.

16. Ausführungsart nach Anspruch 4 und nach einem der vorhergehenden Ansprüche, dadurch gekennzeichnet, dass, jede eine Greifervorrichtung durch ein unabhängiges Steuerungsmittel angesteuert wird.

17. Ausführungsart zum Bewerkstelligen des Verfahrens nach einem der Ansprüche 1 bis 3, dadurch gekennzeichnet, dass die die Plättchen (A) tragenden Körbe (c) auf einen Träger (60) montiert sind, der durch Mittel wie Druckluftzylinder, hydraulische Druckzylinder oder mechanische Kettentriebmittel, Zahnstange oder desgleichen, an einer Führungsbahn oder Führungsmitteln entlang bewegt wird, mit einem Kontaktor für die genaue Stillstandstellung des Trägers und des Korbs in der Nähe eines leeren, von den Beschickungsmitteln getragenen Nachens (D), wobei die genannten Beschickungsmittel aus Trägerstangen bestehen können, die zusammen mit dem Nachen durch Vorrichtungen wie Druckzylinder, mechanische Mittel, bewegt werden, damit die Beschickung, und dann die Entladung aus dem Ofen bewirkt wird ; dass ein einen Querarm (65) tragender Komplex (64) durch ein beliebiges System von Druckzylindern oder mechanischen Mitteln mit Stillstandkontaktoren an einer Führungsstange oder gleichartigem Führungsmittel entlang genau fortbewegt werden kann, wobei die Greifervorrichtung oder Greifervorrichtungen sowie die Veränderungsmittel für die Teilung oder die Abstände zwischen den Plättchen durch Druckzylinder oder mechanische Mittel mit Stillstandkontaktoren auf den Querarm (65) genau verschoben werden können ; dass die Vorschubeinrichtung (E - E1) zum Vorschieben nach oben, unter den Plättchen, sich unterhalb der Stillstandstelle des Trägers (60) und des Korbs (c) befindet, wobei die Führung und die Querverschiebung des Trägers (60) und des Korbs (c) und dann ihre Führung und Querverschiebung bis zur nächsten Behandlungsarbeitsstelle der Plättchen durch geeignete Mittel gestattet und bewirkt werden, indem die genannten Verschiebungen durch Druckzylinder und/oder mechanische Mittel gesteuert sind ; und dass geeignete Berührungsvorrichtungen für eine genaue Positionierung in den verschiedenen Verschiebungsvorgängen vorgesehen sind, wobei entsprechende Steuerungen für gleichlaufende Bewegungen eingesetzt werden.

FIG.1

FIG.2

FIG.6

FIG.3

FIG.7

FIG.5

FIG.4

FIG.8

FIG.9

FIG.10

FIG.11

FIG.12

FIG.13

FIG.14

FIG.17

FIG.15

FIG.16

FIG.18

FIG 19

FIG.20

FIG.21

FIG.22

FIG.23

FIG. 24

FIG.25

FIG 26